# EUROPEAN PATENT APPLICATION

(11) **EP 2 264 226 A1**
(43) Date of publication of application: **22.12.2010**
(21) Application number: 09728887.2
(22) Date of filing: 23.03.2009
(51) Int. Cl.: C30B 29/06, C03B 20/00, C30B 15/10

(54) **QUARTZ GLASS CRUCIBLE AND PROCESS FOR PRODUCING THE SAME**

(30) Priority: 31.03.2008 JP 2008090655
(71) Applicant: Japan Super Quartz Corporation, Akita-shi Akita 010-0065 (JP)
(72) Inventor: HARADA, Kazuhiro, Akita-shi Akita 010-0065 (JP); SATO, Tadahiro, Akita-shi Akita 010-0065 (JP); SATO, Masaru, Akita-shi Akita 010-0065 (JP)
(74) Representative: Gulde Hengelhaupt Ziebig & Schneider
(86) International application number: PCT/JP2009/055610
(87) International publication number: WO 2009/122936

(57) **Abstract**

Provided is a vitreous silica crucible for pulling a silicon single crystal, having an inner surface layer which is excellent in uniformity and has a low bubble content rate, and a method of manufacturing the same. Provided is a method of manufacturing a vitreous silica crucible for pulling a silicon single crystal comprising the step of forming an inner surface layer 30 made of synthetic silica powder, wherein the inner surface layer 30 comprises an inner side portion 31 of the inner surface layer 30, the inner side portion 31 made of a first synthetic silica powder; and a surface side portion 32 of the inner surface layer 30, the surface side portion made of a second synthetic silica powder having a smaller average particle size than that of the first synthetic silica powder. The second synthetic silica powder to form the surface side portion 32 of the inner surface layer 30 has an average particle diameter which is smaller than that of the first synthetic silica powder to form the inner side portion 31 of the inner surface layer 30 by 10 µm or more.

## Description

### TECHNICAL FIELD

The present invention relates to a vitreous silica crucible for pulling a silicon single crystal. Especially, the present invention is preferable to a vitreous silica crucible with an opening diameter of 32 inches or more, and relates to a vitreous silica crucible having an inner surface layer which is excellent in uniformity and has a low bubble content rate, and a method of manufacturing the same.

### BACKGROUND ART

Silicon single crystals used for substrates of semiconductor devices, solar cells, and so on are primarily manufactured by the CZ method. This is a method where highly-pure polycrystalline silicon is charged into a vitreous silica crucible, and is melted under an inactive gas atmosphere. Then, a seed crystal is dipped therein, and gradually pulled so that single crystal silicon is pulled from the silicon melt.

Conventionally, the above-mentioned vitreous silica crucible is manufactured by a rotating mold method and so on (Patent Document 1, 2). In this method, silica powder is deposited on an inner surface of a rotating carbon-made hollow mold so as to form a layer with a constant thickness, and the silica powder is heated and melted to be vitrified to manufacture a vitreous silica crucible.

In the above-mentioned manufacturing method, the crucible inner surface (inner surface layer) is made of highly-pure synthetic silica powder because the crucible inner surface contacts silicon melt. Furthermore, when the inner surface layer has a large bubble content, the bubbles contained in the inner surface layer expands to cause peel off of the inner surface layer during pulling of a silicon single crystal at high temperature. The peeled-off inner surface layer mixes in the silicon melt, which can decrease the single crystallization rate. Here, there has been implemented a method where, in a manufacturing process of a crucible, when a silica powder layer deposited on a mold inner surface is heated and the surface of the silica powder layer is covered with a thin vitreous silica film, the inside of the silica powder layer is suctioned (vacuum-suctioned) from the mold side to remove air from the inside of the silica powder layer to reduce bubbles in the inner surface layer.

According to the above-mentioned manufacturing method, when the surface of the silica powder layer is uniformly melted to form good sealing, the bubble content thereof can be reduced depending on the length of the vacuum-suction. However, along with increase in crucible opening diameter, the uniform surface melting of the silica powder layer has become more difficult, and therefore it has become more frequent that the good sealing has failed to be formed. Therefore, it have become more frequent that a crucible with a large opening diameter contains visible bubbles.
Patent Document 1: Japanese Patent Application Laid Open Hei 02-055285
Patent Document 2: Japanese Patent Application Laid Open Hei 10-017391

### DISCLOSURE OF THE INVENTION

### Problems to be Solved by the Inventions

The present invention solves the above-mentioned conventional problems, and provides a method which can manufacture a vitreous silica crucible having an inner surface layer which is excellent in uniformity and thus has a low bubble content rate, and provides the vitreous silica crucible.

### Means for Solving the Problems

According to the present invention, provided are a method of manufacturing a vitreous silica crucible, and a vitreous silica crucible, which solve the above-mentioned problems by the following configurations.
[1] A method of manufacturing a vitreous silica crucible for pulling a silicon single crystal including the step of forming an inner surface layer made of synthetic silica powder, wherein synthetic silica powder to form a surface side portion of the inner surface layer has a smaller average particle size than that of synthetic silica powder to form an inner side portion of the inner surface layer.
[2] The method of the above [1], wherein the synthetic silica powder to form the surface side portion of the crucible inner surface layer has an average particle diameter which is smaller than that of the synthetic silica powder to form the inner side portion of the inner surface layer by 10 µm or more.
[3] The method of the above [1] or [2], wherein 90 % or more of the synthetic silica powder to form the surface side portion of the crucible inner surface layer has a particle diameter of 200 µm or less
[4] The method of any one of the above [1] to [3], wherein the synthetic silica powder to form the inner side portion of the crucible inner surface layer has an average particle diameter of 160 µm or more, and the synthetic silica powder to form the surface side portion of the inner surface layer has an average particle diameter of 150 µm or less.
[5] A vitreous silica crucible for pulling a silicon single crystal, made by a method of any one of the above [1] to [4], wherein, in an inner surface layer of 1 mm or less from the inner surface, the number of bubbles having a diameter of larger than 0.5 mm is 10 or less, and a bubble content rate of bubbles having a diameter of 0.5 mm or less is 0.1 vol. % or less.
[6] A vitreous silica crucible including an outer layer made of vitreous silica formed from natural quartz powder; and an inner surface layer made of vitreous silica formed from synthetic silica powder,
   wherein the inner surface layer comprises an inner side portion of the inner surface layer, the inner side portion made of a first synthetic silica powder; and a surface side portion of the inner surface layer, the surface side portion made of a second synthetic silica powder which has a smaller average particle size than that of the first synthetic silica powder, and, in the inner surface layer of 1 mm or less from the inner surface, the number of bubbles having a diameter of larger than 0.5 mm is 10 or less, and a bubble content rate of bubbles having a diameter of 0.5 mm or less is 0.1 vol. % or less.

### EFFECT OF THE INVENTION

According to a manufacturing method of the present invention, because a surface side portion of a crucible inner surface layer is made of silica powder having a small average particle diameter, the surface side portion is heated and melted to be easily and uniformly melted and thus to form a uniform thin vitreous silica film on a surface of the silica powder layer. Therefore, good sealing condition is achieved and thus gas existing in the silica powder surface can be efficiently removed by a vacuum pump. When silica powder with a small average particle diameter is used, a number of microbubbles are formed. However, a thin vitreous silica layer on a silica layer surface containing microbubbles is evaporated when synthetic silica powder and natural quartz powder are vitrified until they are fused together. Therefore, the inner surface layer becomes a transparent vitreous silica layer hardly containing bubbles. Therefore, a vitreous silica crucible with significantly less bubbles in the inner surface layer can be obtained even when the vitreous silica crucible has a large size.

### BRIEF DESCRIPTION OF THE DRAWINGS

Fig. 1 is a partial sectional schematic view illustrating a lamination state of silica powder on a mold inner surface
Fig. 2 is a graph illustrating a bubble content rate in Reference Example 2

### EXPLANATION OF REFERENCE SYMBOL

10-mold, 11-mold inner surface , 20-outer layer portion (natural quartz), 30-inner surface layer, 31-inner side portion of the inner surface layer, 32-surface side portion of the inner surface layer

### BEST EMBODIMENT FOR CARRYING OUT THE INVENTION

The present invention will be specifically explained below based on an embodiment of the present invention.

The present invention provides a method of manufacturing a vitreous silica crucible for pulling a silicon single crystal including the step of forming an inner surface layer made of synthetic silica powder, wherein a synthetic silica powder to form a surface side portion of the inner surface layer has a smaller average particle size than that of a synthetic silica powder to form an inner side portion of the inner surface layer.

When a vitreous silica crucible is manufactured by the rotating mold method, a round-bottom freely-rotatable mold is used, and, for example, natural quartz powder is deposited on an inner surface of the rotating mold with an upper opening to form an outer layer portion with a constant thickness, and thereafter synthetic silica powder is deposited thereon to form an inner surface layer portion, and the thus-shaped silica powder is melted to be vitrified by high temperature heating caused by arc discharge caused by electrodes provided on a central axis of the mold

During this heating and melting, the silica powder layer is vacuum-suctioned through a number of ventilation holes provided in the mold, and the inside of the silica powder layer is subject to a reduced pressure so that suctioned air therein is removed and vitreous silica layer with a small bubble content is formed. The vitreous silica layer is cooled thereafter, and a round-bottom vitreous silica crucible is taken out of the mold.

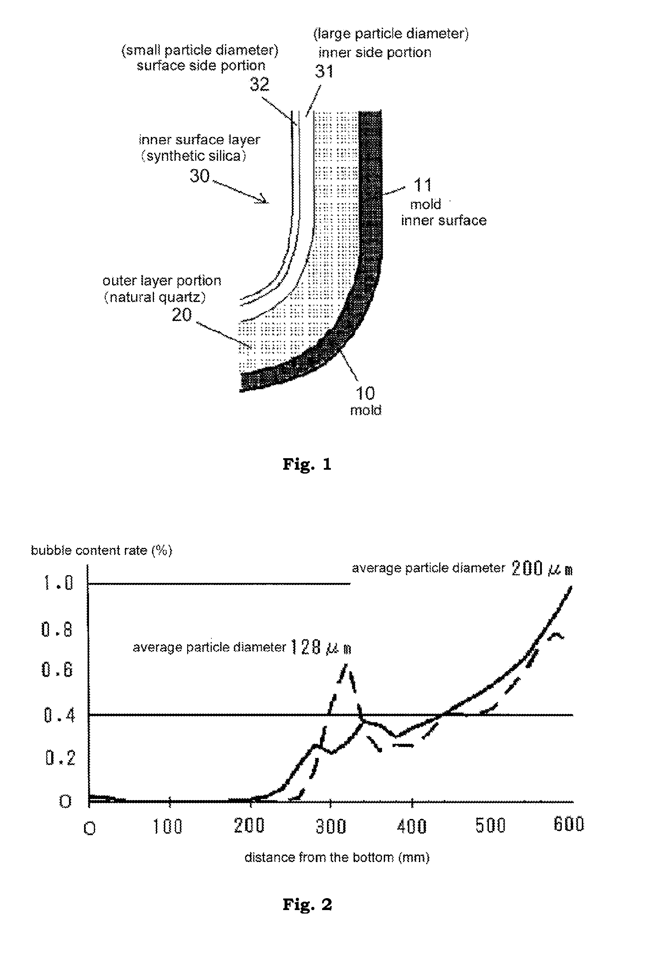

In the above-mentioned manufacturing method of the present invention, as shown in Fig. 1, when natural quartz powder is deposited on an inner surface 11 of a mold 10 to form an outer layer 20, and thereafter synthetic quartz powder is deposited on the outer layer 20 to form an inner surface layer 30, synthetic silica powder (a first synthetic silica powder ) with a large average particle diameter is deposited on the outer layer 20 to form an inner side portion 31 of the inner surface layer 30, and synthetic silica powder (a second synthetic silica powder) with a small average particle diameter is used to form a surface side portion 32 of the inner surface layer 30.

The second synthetic silica to form the surface side portion 32 of the inner surface layer 30 is preferred to have an average particle diameter which is smaller than that of the synthetic silica powder to form the inner side portion 31 of the inner surface layer 30 by 10 µm or more. Specifically, for example, the synthetic silica powder to form the inner side portion 31 of the crucible inner surface layer 30 has an average particle diameter of 160 µm or more, and the synthetic silica powder to form the surface side portion 32 of the inner surface layer 30 has an average particle diameter of 150 µm or less.

20 % or more of the first synthetic silica powder to form the inner side portion 31 of the crucible inner surface layer 30 has a particle diameter of 200 µm or more, and 90 % or more of the second synthetic silica powder to form the surface side portion 32 of the inner surface layer 30 has a particle diameter of 200 µm or less

It should be noted that, for example, a layer made of the second synthetic silica powder with a small average particle diameter placed on the inner surface layer is preferred to have a thickness of 0.3 to 1.0 mm.

When the outer layer 20 made of natural quartz powder and the inner surface layer 30 made of synthetic silica powder each deposited on the mold inner surface is heated and melted to be vitrified, the surface side portion 32 is easily and uniformly melted because the surface side portion 32 is made of the second synthetic silica powder with a small average particle diameter. Therefore, a uniform thin vitreous silica film is formed on the surface of the inner surface layer 30 made of synthetic silica powder, and thus good sealing condition is achieved.

When silica powder with a small average particle diameter is used, a number of microbubbles are formed. However, a thin vitreous silica layer on the silica layer surface containing microbubbles is evaporated when synthetic silica powder and natural quartz powder are vitrified until they are fused together. Therefore, the inner surface layer 30 becomes a transparent vitreous silica layer hardly containing bubbles.

Furthermore, because good sealing condition is achieved by a thin vitreous silica film in the surface side portion 32 of the inner surface layer 30 made of synthetic silica powder, inner bubbles in the inner surface layer 30 made of synthetic silica powder is suctioned outwardly and thus a vitreous silica crucible containing significantly less bubbles can be obtained.

On the other hand, when the entire inner surface layer 30 is made of synthetic silica powder with a large average particle diameter, for example, an average particle diameter of 200µm, the inner surface layer 30 made of synthetic silica powder is, when heated and melted, ununiformly melted, and thus the surface of the silica powder layer becomes uneven, which can lead to formation of large bubbles.

According to the manufacturing method of the present invention, there can be obtained a vitreous silica crucible wherein, in an inner surface layer of 1 mm or less from the inner surface, the number of bubbles having a diameter of larger than 0.5 mm is 10 or less, and a bubble content rate of bubbles having a diameter of 0.5 mm or less is 0.1 vol. % or less.

### Example

Hereinafter, examples of the present invention will be illustrated.

### [Reference Example 1]

A vitreous silica crucible with an opening diameter of 32 inches was manufactured by the above-mentioned rotating mold method, using synthetic silica powder A with an average particle diameter of 175 µm and synthetic silica powder B with an average particle diameter of 200 µm. Bubbles contained in the inner surface layer with a thickness of 6 mm were studied. Thu number of bubbles with a diameter of 1 mm or more was 3.5 in synthetic silica powder A and 6 in synthetic silica powder B. This result shows that the number of bubbles with a diameter of 1 mm or more tends to increase as the average particle diameter of silica powder increases.

### [Reference Example 2]

A vitreous silica crucible with an opening diameter of 24 inches was manufactured by the above-mentioned rotating mold method, using synthetic silica powder C with an average particle diameter of 128 µm and synthetic silica powder B with an average particle diameter of 200 µm. The bubble content rate of bubbles with a diameter of 0.5 mm or less in the inner surface layer with a thickness of 6 mm was studied. The result was shown in Fig. 2. In Fig. 2, X axis refers to a distance (mm), along the wall, from the crucible bottom center to the rim upper end. A range from 0 to 250 mm refers to the bottom section, a range from 250 to 350 mm refers to the corner section (curved section), and a range from 350 to 600 mm refers to the straight body section. As apparent from Fig. 2, in the crucible corner section (curved section), the bubble content rate of synthetic silica powder C was about twice of that of synthetic silica powder B, and synthetic silica powder C with a smaller average particle diameter had a larger bubble content rate with regards to bubbles with a diameter of 0.5 mm or less. That is, when silica powder with a small average particle diameter is used not only in a region near the surface of the crucible inner surface layer, but also in the entire inner surface layer, the bubble content rate of relatively small bubbles with a diameter of 0.5 mm or less tends to become very high on the crucible corner section.

### [Example 1]

A vitreous silica crucible with an opening diameter of 32 inches was manufactured with a surface side portion (a layer thickness of 0.5 mm) of the crucible inner surface layer made of synthetic silica powder with an average particle diameter of 128 µm and with an inner side portion (a layer thickness of 5.5 mm) of the inner surface layer made of synthetic silica powder with an average particle diameter of 175 µm. The outside of the inner surface layer was formed of natural quartz powder. The bubble content rate of bubbles with a diameter of 0.5 mm or less was measured in a region with a layer thickness from the inner surface to 1 mm, and the number of bubbles with a diameter of more than 0.5 mm was measured. The result was shown in Table 1.

### [Comparative Example 1]

A vitreous silica crucible with an opening diameter of 32 inches was manufactured with the entire inner surface layer (a layer thickness of 6.0 mm) made of synthetic silica powder with an average particle diameter of 175 µm. The outside of the inner surface layer was formed of natural quartz powder. The manufactured vitreous silica crucible was subjected to measurement of the bubble content rate and the number of bubbles in the same way as Example 1. The result was shown in Table 1.

### [Comparative Example 2]

A vitreous silica crucible with an opening diameter of 32 inches was manufactured with the entire inner surface layer (a layer thickness of 6.0 mm) made of synthetic silica powder with an average particle diameter of 128 µm. The outside of the inner surface layer was formed of natural quartz powder. The manufactured vitreous silica crucible was subjected to measurement of the bubble content rate and the number of bubbles in the same way as Example 1. The result was shown in Table 1.

According to Example 1, there was obtained a vitreous silica crucible, wherein, in a range within 1 mm from the inner surface made of synthetic silica powder, the bubbles with a diameter of larger than 0.5 mm was 10 or less (4 in Example 1), and the bubble content rate of bubbles with a diameter of 0.5 mm or less was 0.1 vol. % (0.06 vol. % in Example 1).

On the other hand, in the vitreous silica crucible of Comparative Example 1, the bubble content rate of bubbles with a diameter of 0.5 mm or less was as low as 0.05 %, but the number of bubbles with a diameter of larger than 0.5 mm was as many as 30. In the vitreous silica crucible of Comparative Example 2, the number of bubbles with a diameter of larger than 0.5 mm was as few as 4, but the bubble content rate of bubbles with a diameter of 0.5 mm or less was as high as 0.2 %.

**[Table 1]**

| | Example 1 | Comparative Example 1 | Comparative Example 2 |
|---|---|---|---|
| Bubble content rate (Diameter ≦ 0 5 mm) | 0.06 % | 0.05% | 0.2% |
| Number of bubbles (diameter > 0.5 mm) | 4 | 30 | 4 |

## Claims

1. A method of manufacturing a vitreous silica crucible for pulling a silicon single crystal comprising the step of forming an inner surface layer made of synthetic silica powder, wherein the inner surface layer comprises an inner side portion of the inner surface layer, the inner side portion made of a first synthetic silica powder; and a surface side portion of the inner surface layer, the surface side portion made of a second synthetic silica powder which has a smaller average particle size than that of the first synthetic silica powder.

2. The method of claim 1, wherein the second synthetic silica powder has an average particle diameter which is smaller than that of the first synthetic silica powder by 10 µm or more.

3. The method of claim 1, wherein 90 % or more of the second synthetic silica powder has a particle diameter of 200 µm or less.

4. The method of claim 1, wherein the first synthetic silica powder has an average particle diameter of 160 µm or more, and the second synthetic silica powder has an average particle diameter of 150 µm or less.

5. A vitreous silica crucible made by a method of claim 1, wherein, in an inner surface layer of 1 mm or less from the inner surface, the number of bubbles having a diameter of larger than 0.5 mm is 10 or less, and a bubble content rate of bubbles having a diameter of 0.5 mm or less is 0.1 vol. % or less.

6. A vitreous silica crucible comprising an outer layer made of vitreous silica formed from natural quartz powder; and an inner surface layer made of vitreous silica formed from synthetic silica powder,
wherein the inner surface layer comprises an inner side portion of the inner surface layer, the inner side portion made of a first synthetic silica powder; and a surface side portion of the inner surface layer, the surface side portion made of a second synthetic silica powder which has a smaller average particle size than that of the first synthetic silica powder, and, in the inner surface layer of 1 mm or less from the inner surface, the number of bubbles having a diameter of larger than 0.5 mm is 10 or less, and a bubble content rate of bubbles having a diameter of 0.5 mm or less is 0.1 vol. % or less.
